Europäisches Patentamt

European Patent Office

Office européen des brevets

(19)

(11) EP 0 579 366 B1

## (12) EUROPEAN PATENT SPECIFICATION

(45) Date of publication and mention
of the grant of the patent:
**12.09.2001 Bulletin 2001/37**

(51) Int Cl.$^7$: **G06F 11/20**

(21) Application number: **93304210.3**

(22) Date of filing: **01.06.1993**

(54) **Redundancy circuits for semiconductor memory devices**

Redundanzschaltung für Halbleiterspeichergeräte

Circuits de redondance pour dispositifs de mémoire à circuit intégré

(84) Designated Contracting States:
**DE FR GB IT**

(30) Priority: **13.07.1992 KR 1243692**

(43) Date of publication of application:
**19.01.1994 Bulletin 1994/03**

(73) Proprietor: **SAMSUNG ELECTRONICS CO., LTD.**
**Suwon-city, Kyungki-do 441-373 (KR)**

(72) Inventor: **Lee, Kyu-Chan**
**Ahnsan-city, Kyungki-do (KR)**

(74) Representative: **Stanley, David William et al**
**DIBB LUPTON**
**BROOMHEAD**
**117 The Headrow, Leeds LS1 5JX (GB)**

(56) References cited:
**EP-A- 0 094 645**          **EP-A- 0 180 212**
**EP-A- 0 335 149**          **GB-A- 2 251 101**
**US-A- 5 159 415**

- **IEEE JOURNAL OF SOLID-STATE CIRCUITS,
  vol. 26, no. 1, January 1991, NEW YORK, US,
  pages 12-17, XP002001449 M. HORIGUCHI ET
  AL.: "A Flexible Redundancy Technique for
  High-Density DRAM's"**
- **PATENT ABSTRACTS OF JAPAN vol. 17, no. 40
  (P-1475) & JP-A-04 255998 (NEC IC
  MICROCOMPUT SYST LTD), 10 September 1992,
  & US-A-5 361 231 (HAYANO) 1 November 1994**

**Description**

The present invention relates to semiconductor memory devices, and more particularly to row redundancy circuits for repairing row defects generated in a given memory cell by the use of a spare memory cell (hereinafter referred to as a redundant memory cell).

As is well known in the art, a semiconductor memory device has a plurality of memory cells arranged in a matrix shape of columns and rows, and as the capacity of a memory is increased, the semiconductor memory device contains more memory cells. In a semiconductor memory device, if defects are generated in any one memory cell, the semiconductor memory device may not be usable. In order to improve yield even if there is a defective memory cell, a method for replacing the defective normal memory cell with a redundant memory cell connected to the column and row of a normal memory cell array has been proposed. This redundancy technique is performed by connecting a fuse with each bit line or word line of the semiconductor memory device. Then, if defects are generated in a normal memory cell, the fuse connected to the bit line or word line to which the normal memory cell is coupled is cut by projecting a laser beam, for example. However, as the degree of integration of semiconductor memory devices is greatly increased, it is difficult to connect the fuse with each bit line and word line of a plurality of memory cells contained in one chip. To solve such a problem, another method for decoding a redundant memory cell by an internal address when there is defective normal memory cell has been proposed, and in a row redundancy circuit, this method is generally used.

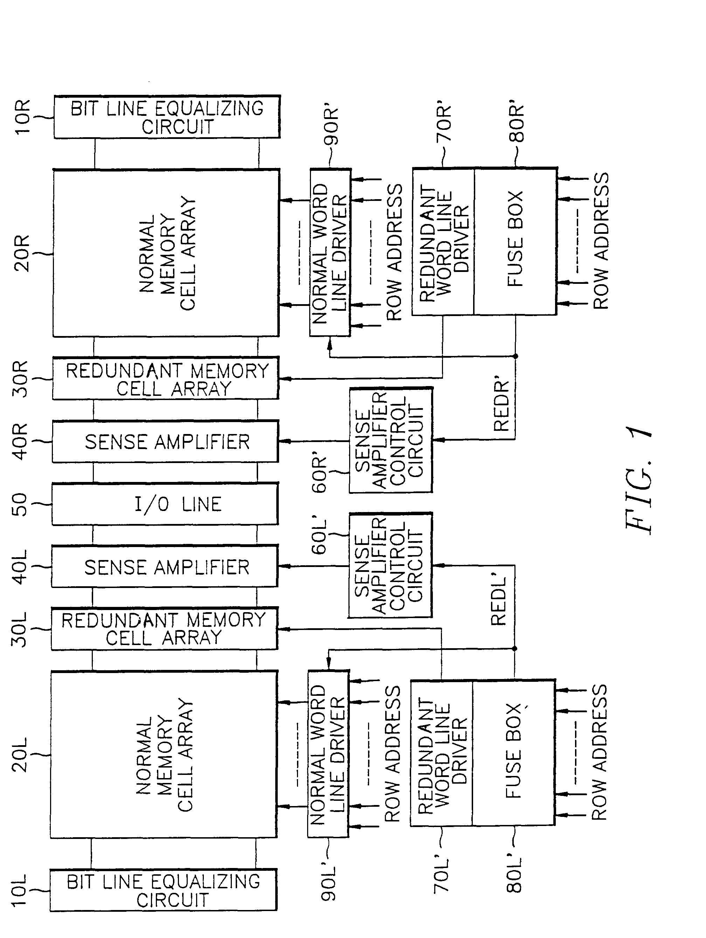

Referring to Figure 1 of the accompanying diagrammatic drawings, a conventional row redundancy circuit using an internal address decoding method is shown. There are provided a first normal memory cell array 20L, a first redundant memory cell array 30L, a second normal memory cell array 20R, and a second redundant memory cell array 30R centered around an input/output (I/O) line 50. Each memory cell group including the redundant and normal memory cell arrays has first and second sense amplifiers 40L, 40R and first and second bit line equalizing circuits 10L, 10R. Moreover, each memory cell group contains first and second sense amplifier control circuits 60L', 60R', first and second redundant word line drivers 70L', 70R', first and second fuse boxes 80L', 80R', and first and second normal word line drivers 90L', 90R'.

Figure 1 shows a partial memory array within one chip, and a plurality of memory arrays are included in one chip. In particular, in a highly integrated semiconductor memory device, there are a great number of memory cells. In the decoding method of the circuit of Figure 1, there is provided a redundant memory cell array corresponding to each normal memory cell array, and the redundant memory cell arrays 30L and 30R are respectively selected by the sense amplifier control circuits 60L' and 60R' in response to redundant address signals REDL' and REDR' generated from the fuse boxes 80L' and 80R'. In this case, the outputs of the redundant memory cell arrays 30L and 30R are enabled by the redundant word line drivers 70L' and 70R'. That is, if defects are generated in the first normal memory cell array 20L, the first redundant memory cell array 30L is used, and if defects are generated in the second normal memory cell array 20R, the second redundant memory cell array 30R is used. For example, if there are defects in the word line of the first normal memory cell array 20L, an address of the defective word line is programmed in the first fuse box 80L' and the redundant word line corresponding to the defective normal word line is enabled in the redundant memory cell array 30L through the redundant word line driver 70L'. Further, the first sense amplifier 40L is enabled through the first sense amplifier control signal 60L' by the output signal REDL' of the first fuse box 80L', and as a result, the redundant word line is selected.

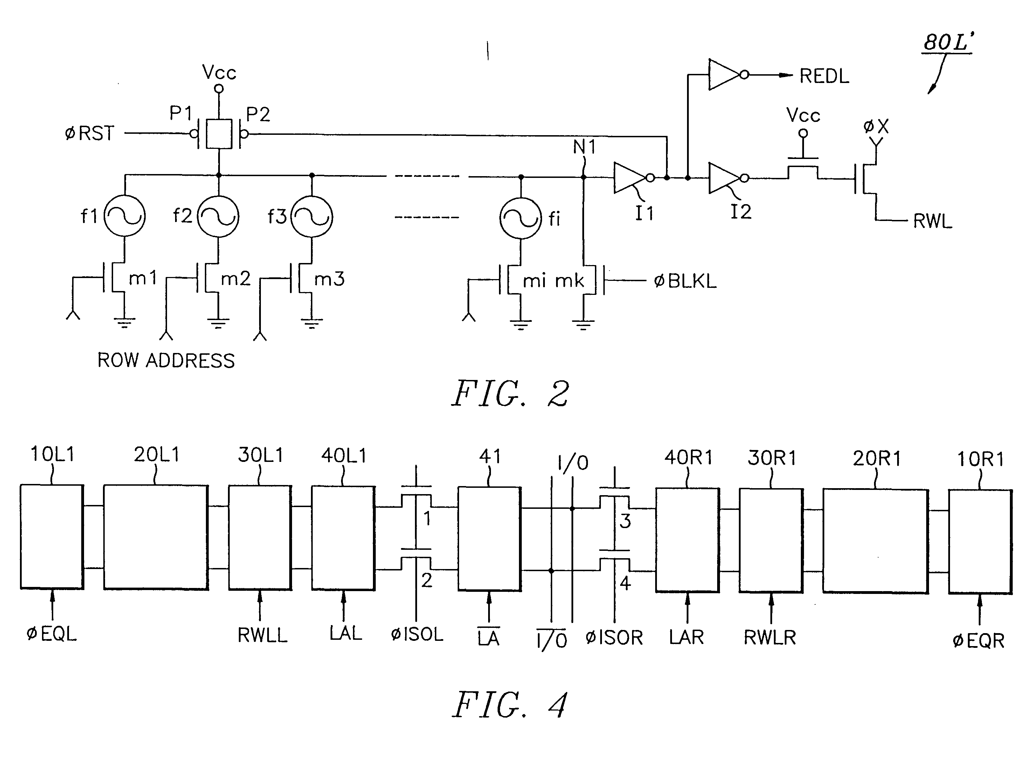

Figure 2 of the accompanying diagrammatic drawings shows a detailed circuit diagram of the first fuse box 80L' for programming the address in which the defects are generated. As shown, one fuse box has a plurality of fuses for receiving row addresses. When redundancy programming, a block selection signal $\phi$BLKL is enabled, and if the defective address is applied, a node N1 is enabled to logic "high" level, thereby enabling a redundant word line RWL.

In the circuit constructed in such a manner, the normal memory cell array 20L or 20R which is included in one chip with a large number of cases has a fuse box one to one shown in Figure 2. In order to raise the probability of redundancy, at least one or more fuse box is further needed. Then, the number of fuse boxes becomes more and more increased in a highly integrated semiconductor memory device. Further, the number of redundant memory cell arrays capable of containing one normal memory cell array 20L or 20R is limited. Accordingly, the number of repairable word lines is limited by that of the redundant word lines within the redundant memory cell array. Although a defective word line does not exist, for example, in the first normal memory cell array 20L, if the number of defective word lines generated in the second normal memory cell array 20R is greater than that of the redundant word lines of the second redundant memory cell array 30R, it is difficult to use the semiconductor memory device. Consequently, an ineffective redundancy operation is performed.

Document EP-A-335 149 discloses a semiconductor memory redundancy scheme wherein left and right sets of redundancy cells may be used to repain either a left or right cell array.

Preferred embodiments of the present invention aim to provide a row redundancy circuit for preventing high integration of a chip from dropping.

It is another aim to provide a row redundancy circuit for performing an effective redundancy operation.

It is a further aim to provide a row redundancy circuit wherein adjacent memory array blocks share a fuse box to prevent the integrated degree of integration of a chip from dropping.

It is yet another aim to provide a row redundancy circuit wherein adjacent memory array blocks share a fuse box to perform an effective repair operation.

It is a still further aim to provide a row redundancy circuit wherein one fuse box controls each sense amplifier of adjacent memory arrays simultaneously.

In accordance with the present invention, there is provided a row redundancy circuit for use in a semiconductor memory device with a plurality of first normal memory cell arrays each having a first redundant memory cell array and a first sense amplifier, and a plurality of second normal memory cell arrays each having a second redundant memory cell array and a second sense amplifier, wherein said first and second sense amplifiers comprise a shared NMOS sense amplifier together with first and second PMOS sense amplifiers, each separated from the NMOS sense amplifier by an isolation gate, the isolation gates being controlled by respective, separate control signals; the circuit comprising:

a first sense amplifier control circuit connected to said first sense amplifier;

a second sense amplifier control circuit connected to said second sense amplifier;

a first fuse box for receiving a row address and a selection signal of said first normal memory cell array, said first fuse box having its output signal commonly connected to the first and second sense amplifier control circuits; and

a second fuse box for receiving a row address and a selection signal of said second normal memory cell array, said second fuse box having its output signal commonly connected_to the first and second sense amplifier control circuits.

Whereby said first fuse box is operable to program a redundancy operation of said first normal memory cell array so that said second redundant memory cell array repairs a defective address of said first normal memory cell array. Preferably, the first fuse box programs the redundancy operation of the first and second normal memory cell arrays simultaneously so that the second redundant memory cell array repairs a defective address of the first normal memory cell array. Since the preferably adjacent first and second normal memory cell arrays share the first and second fuse boxes, the redundancy efficiency is greatly increased.

Preferably, the shared NMOS sense amplifier is enabled faster than either of the first and second PMOS amplifiers.

Preferably, said operation for repairing said defective address is performed when the number of defective word lines produced in said first normal memory cell array is greater than the number of redundant word lines available in said first redundant memory cell array.

Preferably, said semiconductor memory device is further comprising :

a first redundant word line driver for enabling said first redundant memory cell array and a second redundant word line driver for enabling said second redundant memory cell array wherein said first fuse box is operable to control said first and second sense amplifier control circuits during a redundancy operation of said first normal memory cell array

Preferably, the controlling of said first and second sense amplifier control circuits is performed when the number of defective word lines produced in said first normal memory cell array is greater than the number of redundant word lines available in said first redundant memory cell array.

Preferably, said second fuse box is operable to control said first and second sense amplifier control circuits when the number of defective word lines generated in said second normal memory cell array is greater than the number of redundant word lines available in said second redundant memory cell array, during a redundancy operation of said second normal memory cell array.

Preferably, the semiconductor memory device is comprising a plurality of said first normal memory cell arrays, each having an associated first redundant memory cell array and a first sense amplifier; and a plurality of said second normal memory cell arrays, each having an associated second redundant memory cell array and a second sense amplifier.

For a better understanding of the invention, and to show how the same may be carried into effect, reference will now be made, by way of example, to Figures 3 to 8 of the accompanying diagrammatic drawings, in which:

Figure 3 is a block diagram of one example of a row redundancy circuit according to the present invention;

Figure 4 shows a column structure of a memory array of Figure 3;

Figures 5A and 5B are diagrams of circuits for generating bit line equalizing signals of Figure 3;

Figures 6A, 6B and 6C are diagrams of circuits for generating sense amplifier control signals of Figure 3;

Figures 7A and 7B are diagrams of circuits showing examples of a fuse box of Figure 3; and

Figures 8A and 8B are timing charts illustrating when a defective address is applied.

In the figures, like reference numerals denote like or corresponding parts.

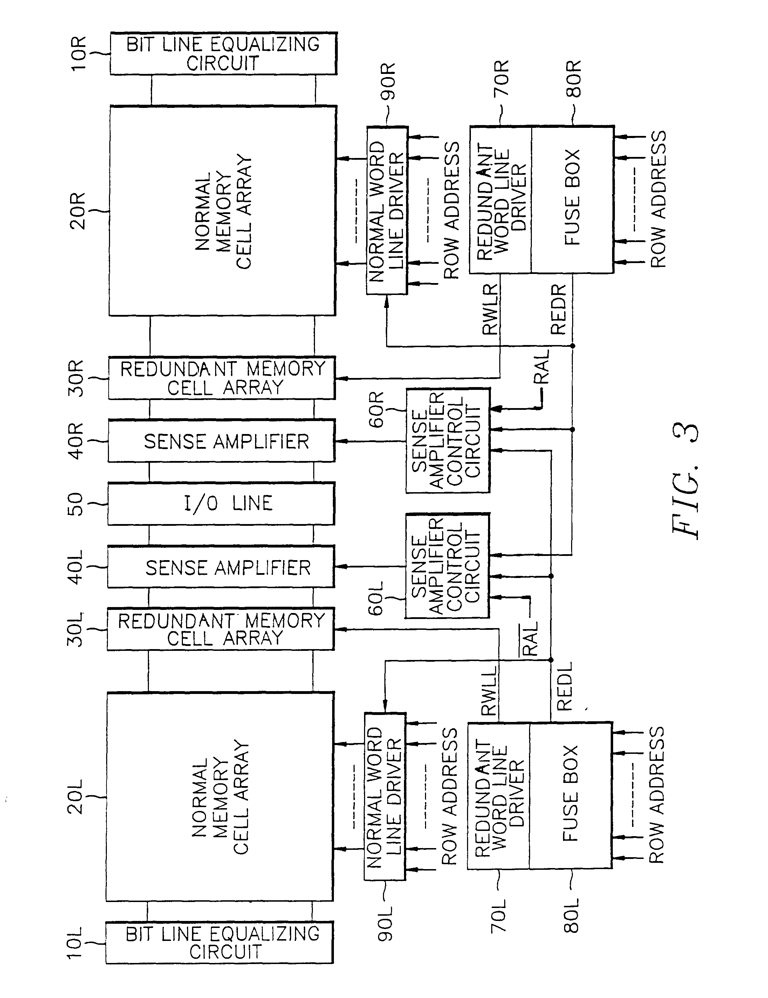

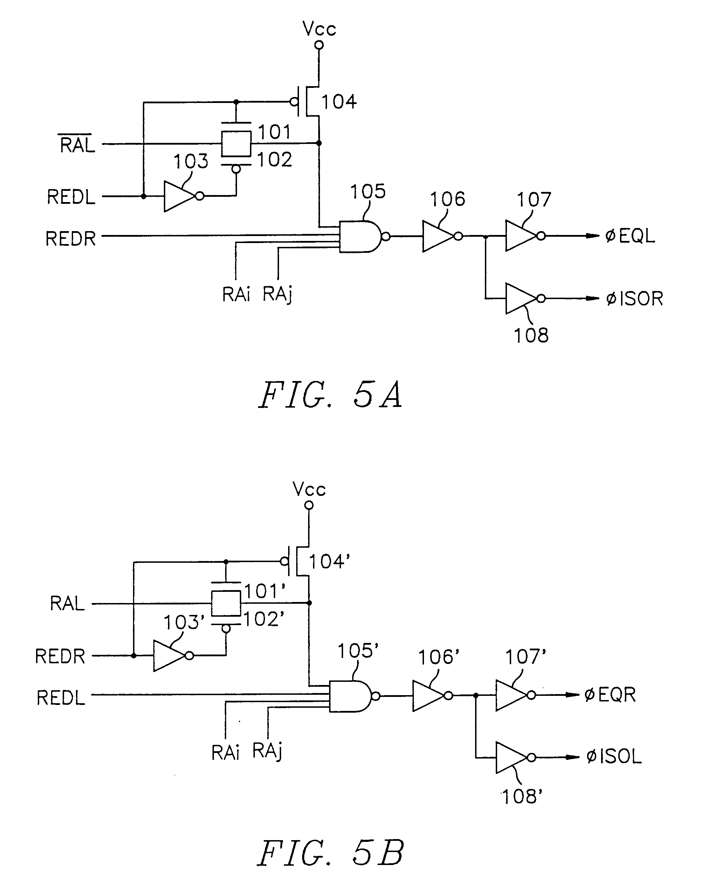

The circuit of Figure 3 has the same configuration as that of Figure 1, except that each of the fuse boxes 80L and 80R is simultaneously connected to sense amplifier control circuits 60L and 60R. However, the detailed circuits and operations thereof are considerably different. Figure 4 illustrates one column of a memory array and respective control signals.

Referring now to Figure 3, first and second sense amplifier control circuits 60L and 60R are respectively connected to first and second sense amplifiers 40L and 40R. The first fuse box 80L receives a row address and selection signal of the first normal memory cell array 20L and has its output signal REDL commonly connected to the first and second sense amplifier control circuits 60L and 60R. The second fuse box 80R receives the row address and selection signal of the second normal memory cell array 20R and has its output signal REDR commonly connected to the first and second sense amplifier control circuits 60L and 60R. First and second redundant word line divers 70L and 70R enable first and second redundant memory cell arrays 30L and 30R, respectively.

If the number of defective word lines in the first normal memory cell array 20L is less than or equal to the number of redundant word lines of the first redundant memory cell array 30L, the row redundancy circuit of Figure 3 performs the same repair operation as that of Figure 1. However, for example, if the number of defective word lines in the first normal memory cell array 20L is greater than the number of redundant word lines of the first redundant memory cell array 30L, the second fuse box 80R of Figure 3 controls the first sense amplifier control circuit 60L by simultaneously programming a redundancy operation of the first normal memory cell array 20L, to disable the first sense amplifier 40L. Moreover, the first fuse box 80L controls the second sense amplifier control signal 60R, to enable the second sense amplifier 40R. Thereby the second redundant memory cell array 30R performs an operation for repairing the defective word line of the first normal memory cell array 20L. Meanwhile, if the number of defective word lines in the second normal memory cell array 20R is greater than the number of redundant word lines of the second redundant memory cell array 30R, the first fuse box 80L controls the second sense amplifier control circuit 60R by programming the redundancy operation of the second normal memory cell array 20R, to disable the second sense amplifier 40R. The second fuse box 80R also controls the first sense amplifier control circuit 60L, to enable the first sense amplifier 40L. Thus the first redundant memory cell array 30L repairs the defective word line of the second normal memory cell array 20R.

In more detail, Figure 4 shows one column of the memory array indicated in Figure 3 and each control signal. The column has the same structure with an array column of Figure 3. The first and second sense amplifiers 40L and 40R of Figure 3, as is well known in the art, consist of first and second PMOS sense amplifiers 40L1 and 40R1 each sharing an NMOS sense amplifier 41. In order to separate the first and second PMOS sense amplifiers 40L1 and 40R1, there are provided isolation gates 1, 2 and 3, 4 controlled by separate control signals $\phi$ISOL and $\phi$ISOR, respectively. The configuration of each block of Figure 4 is well known in the art and various known circuits forms can be used. Thus no further details of these circuits will be given here.

Each control signal of Figure 4 is generated from the circuits of Figures 5A, 5B, 6A, 6B, 6C, 7A and 7B.

Bit line equalizing control signals $\phi$EQL and $\phi$EQR of first and second bit line equalizing circuits 10L1 and 10R1, and the isolation control signals $\phi$ISOL and $\phi$ISOR are generated from the circuits of Figures 5A and 5B. A signal $\overline{RAL}$ of Figure 5A is for selecting a first cell array 20L1, and a signal RAL of Figure 5B is for selecting a second cell array 20R1. Signals RAi and RAj are for selecting the entire blocks of Figure 3. That is, the signals RAi and RAj are row address signals for selecting the blocks of Figure 3 among a plurality of arrays in the chip. In the normal mode of operation, if the first cell array 20L1 is selected, the signals $\overline{RAL}$, REDL, REDR, RAi and RAj of Figure 5A are set to logic "high" level and the output of a NAND gate 105 is set to logic "low" level. Therefore, the bit line equalizing control signal $\phi$EQL and the separate control signal $\phi$ISOR are set to logic "low" level, and the output of the first cell array 20L1 of Figure 4 is enabled.

On the other hand, in the normal mode of operation, if the second cell array 20R1 is selected, the signals RAL, REDR, REDL, RAi and RAj of Figure 5B are set to logic "high" level and the output of a NAND gate 105' is set to logic "low" level. Hence, the control signals $\phi$EQR and $\phi$ISOL are also set to logic "low" level and the output of the second cell array 20R1 of Figure 4 is enabled.

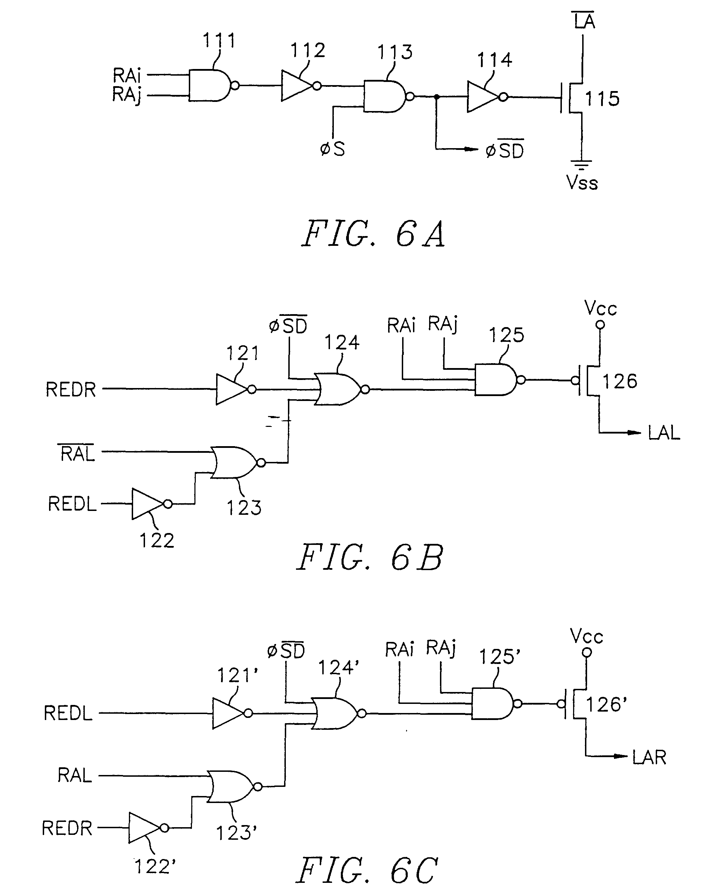

Sense amplifier control signals $\overline{LA}$, LAL and LAR of the sense amplifiers 41, 40L1 and 40R1 of Figure 4 are generated from the circuits of Figures 6A, 6B and 6C. Figure 6A shows the circuit for generating the signal $\overline{LA}$ controlling the NMOS sense amplifier 41 of Figure 4. A signal $\phi$S is enabled to logic "high" level during a data sensing operation. If the first or second cell array is selected, the signals RAi, RAj and $\phi$S are all set to logic "high" level. Hence, an NMOS transistor 115 is turned on and the signal $\overline{LA}$ of logic "low" level is generated. The signal $\overline{LA}$ of logic "low" level enables the NMOS sense amplifier 41 of Figure 4.

Figure 6B shows the circuit for generating the signal LAL controlling the first PMOS sense amplifier 40L1. A signal $\phi$S is delayed during a given time, to generate a signal $\phi\overline{SD}$ as shown in Figure 6A and this signal $\phi\overline{SD}$ enables the NMOS sense amplifier 41 faster than the PMOS sense amplifier 40L1 or 40R1. In Figure 4, when the first PMOS sense amplifier 40L1 is selected, in order to use the first redundant memory cell array 30L for the redundancy operation of the second normal memory cell array 20R, the signal LAL must be set to logic "high" level. Therefore, if the first PMOS sense amplifier 40L1 is selected, the signals RAi, RAj, REDR and $\overline{RAL}$ are set to logic "high" level and the signals REDL and $\phi\overline{SD}$ are set to logic "low" level. Thus the signal LAL of logic "high" level is produced and the PMOS sense amplifier 40L1 of Figure 4 is enabled.

Figure 6C shows the circuit for generating the signal LAR controlling the second PMOS sense amplifier 40R1. When the second PMOS sense amplifier 40R1 is selected, in order to use the second redundant memory cell array 30R for the redundancy operation of the first normal memory cell array 20L, the signal LAR must be set to logic "high" level. Therefore, when the second PMOS sense amplifier 40R1 is selected, the signals RAi, RAj, REDL and RAL of logic "high" level and the signals REDR and $\phi\overline{SD}$ of logic "low" level are applied. As a result, the signal LAR of logic "high" level is generated and the PMOS sense amplifier 40R1 of Figure 4 is enabled.

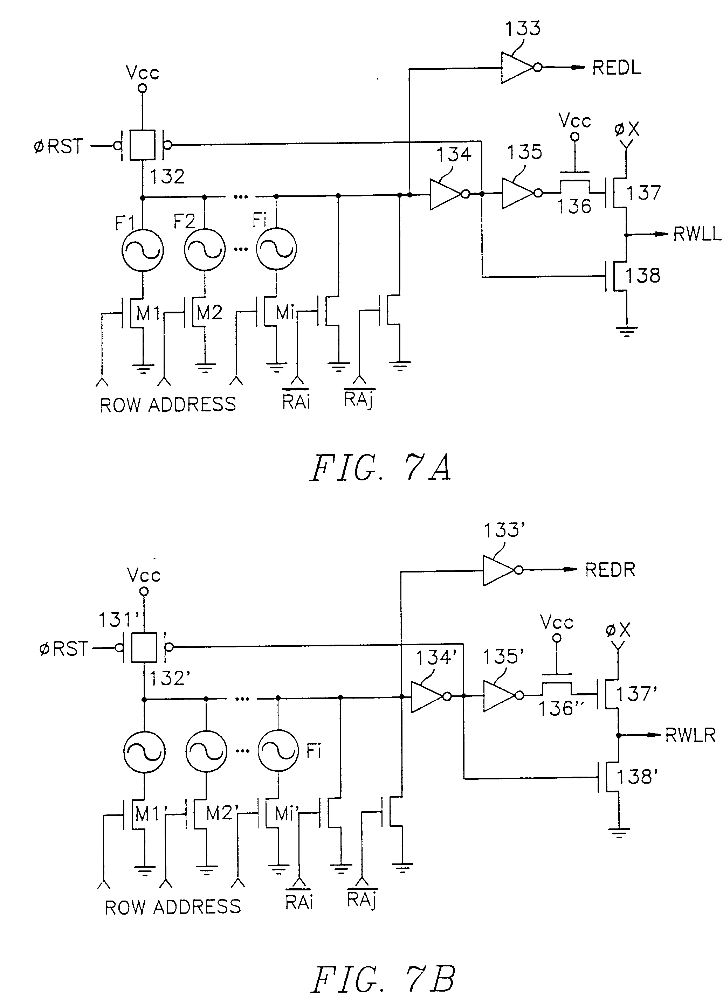

The redundant enable signals REDL and REDR for controlling the first and second sense amplifier control circuits 60L and 60R of Figure 3 during a redundancy operation are generated from the fuse box circuits shown in Figures 7A and 7B. Referring to Figures 7A and 7B, NMOS transistors 137, 138 and 137', 138' are the redundant word line driver circuit and enable redundant word lines RWLL and RWLR, respectively. It should be noted that if a defective address is applied, the signals REDL and REDR are set to logic "low" level through a program such as a fuse cutting operation.

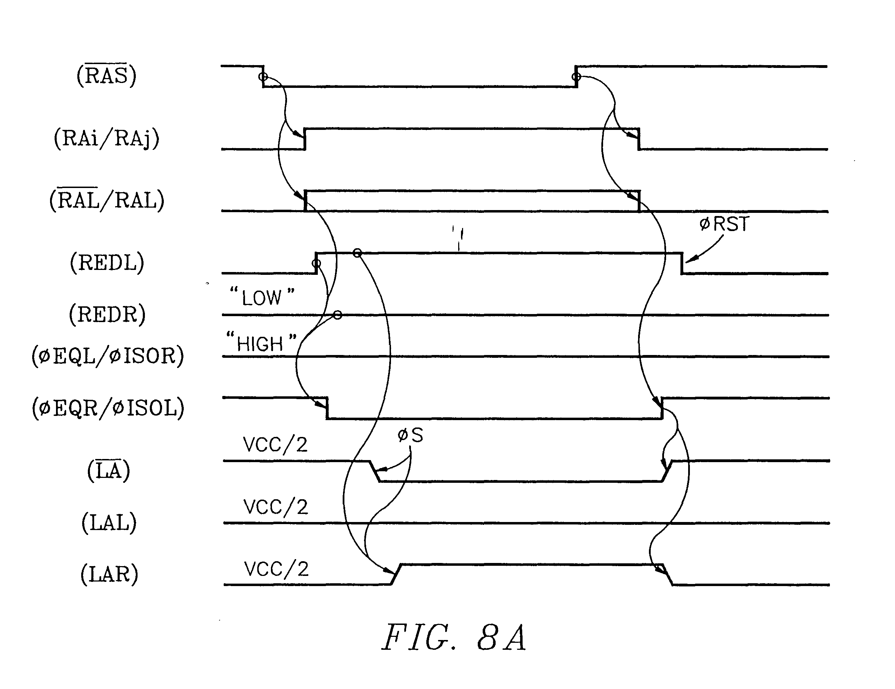

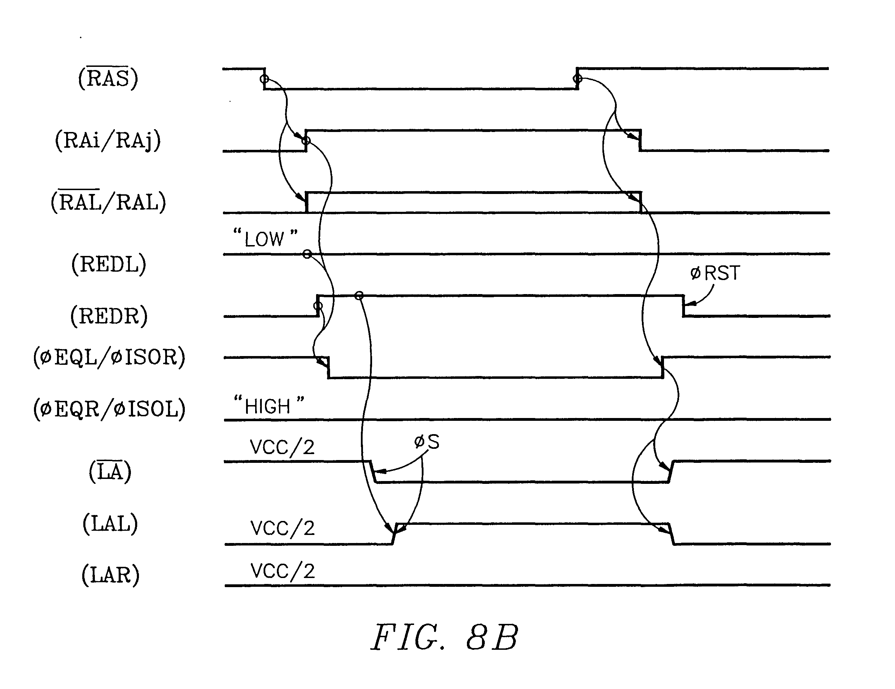

The redundancy operation of Figure 3 configured in accordance with Figures 5A, 5B, 6A, 6B, 6C, 7A and 7B will now be described with reference to the timing charts of Figures 8A and 8B.

Assuming that one redundant word line exists in the first and second redundant memory cell arrays 30L and 30R, respectively and one defective word line is generated in the first normal memory cell array 20L, since the redundant word line included in the first redundant memory cell array 30L is sufficiently capable of repairing the defective word line, the same redundancy operation as the circuit of Figure 1 is performed. If the number of redundant word lines contained in the first redundant memory cell array 30L is 1 and the number of defective word lines generated in the first normal memory cell array 20L is 2, it is readily appreciated that it is difficult to repair all of the defective word lines by the use of the redundant word line in the first redundant memory cell array 30L. However, as shown in Figure 8A, in case of an occurrence of another defective word line, the signal REDR of logic "low" level is generated from the defective address in the fuse box of Figure 7B and the signal REDL of the fuse box of Figure 7A is set to logic "high" level by the defective address used in the signal REDR. The signals REDL and REDR are supplied to the circuits of Figure 6B and 6C. Therefore, the signal LAR of logic "high" level is generated and the redundant word line RWLR of the fuse box of Figure 7B is enabled. Then the redundant word line of the second redundant memory cell array 30R of Figure 3 is enabled and the other defective word line generated in the first normal memory cell array 20L is repaired.

Next, assuming that the number of redundant word lines included in the first and second redundant memory cell arrays 30L and 30R is 1, respectively, and the number of defective word lines generated in the second normal memory cell array 20R is 2, the signal REDL of logic "low" level is generated from the defective address in the fuse box of Figure 7A as shown in Figure 8B. In addition, the signal REDR of the fuse box of Figure 7B is set to logic "high" level by the defective address used in the signal REDL and the signals REDR and REDL are applied to the circuits of Figures 6B and 6C. Hence, the signal LAL of logic "high" level is generated and the word line RWLL of the fuse box of Figure 7A is enabled. Consequently, the redundant word line of the first redundant memory cell array 30L of Figure 3 is enabled and the other defective word line generated in the second normal memory cell array 20R is repaired. By so doing, even if the number of defective word lines in the normal memory cell array is greater than that of the redundant word line included in the redundant memory cell array, there is no necessity for increasing the fuse box, which must otherwise have been required in each normal memory cell array.

In the above-described example of a row redundancy circuit embodying the present invention, since one fuse box controls each sense amplifier of adjacent memory arrays simultaneously, there is no need to increase the size of the fuse box for raising the redundancy efficiency. Therefore, the integration of the chip is prevented from dropping and the redundancy efficiency is greatly increased when compared with a conventional row redundancy circuit.

While preferred embodiments of the present invention have been particularly shown and described, it will be understood by those skilled in the art that foregoing and other changes in form and details may be made without departing from the scope of the present invention.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

**Claims**

1. A semiconductor memory device having a row redundancy circuit and comprising :

   a first normal memory cell array (20L) having an associated first redundant memory cell array (30L) and a first sense amplifier (40L); a second normal memory cell array (20R) adjacent to said first normal memory cell array (20L) and having an associated second redundant memory cell array (30R) and a second sense amplifier (40R) ; wherein said first and second sense amplifiers comprise a shared NMOS sense amplifier (41) together with first and second PMOS sense amplifiers (40L1, 40R1), each separated from the NMOS sense amplifier by an isolation gate (1,2;3,4), the isolation gates being controlled by respective, separate control signals (ØISOL, ØISOR) ; a first sense amplifier control circuit (60L) connected to said first sense amplifier (40L) ; a second sense amplifier control circuit (60R) connected to said second sense amplifier (40R) ; a first fuse box (80L) for receiving a row address and a selection signal of said first normal memory cell array (20L) said first fuse box (80L) having its output signal commonly connected to said first and second sense amplifier control circuits (60L,60R); and a second fuse box (80R) for receiving a row address and a selection signal of said second normal memory cell array (20R), said second fuse box (80R) having its output signal commonly connected to said first and second sense amplifier control circuits (60L, 60R); whereby said first fuse box (80L) is operable to program a redundancy operation of said first normal memory cell array (20L) so that said second redundant memory cell array (30R) repairs a defective address of said first normal memory cell array (20L).

2. A semiconductor memory device as claimed in claim 1, wherein, in use, the shared NMOS sense amplifier is enabled faster than either of the first and second PMOS amplifiers.

3. A device as claimed in claim 1 or claim 2, wherein said operation for repairing said defective address is performed when the number of defective word lines produced in said first normal memory cell array (20L) is greater than the number of redundant word lines available in said first redundant memory cell array (30L).

4. A semiconductor memory device as claimed in any preceding claim, further comprising :

   a first redundant word line driver (70L) for enabling said first redundant memory cell array (30L) ; and a second redundant word line driver (70R) for enabling said second redundant memory cell array (30R) ; wherein said first fuse box (80L) is operable to control said first and second sense amplifier control circuits (60L, 60R) during a redundancy operation of said first normal memory cell array (20L).

5. A device as claimed in claim 4, wherein said operation for controlling said first and second sense amplifier control circuits (60L, 60R) is performed when the number of defective word lines produced in said first normal memory cell array (20L) is greater than the number of redundant word lines available in said first redundant memory cell array (30L).

6. A device as claimed in any preceding claim wherein said second fuse box (80R) is operable to control said first and second sense amplifier control circuits (60L, 60R) when the number of defective word lines generated in said second normal memory cell array (20R) is greater than the number of redundant word lines available in said second redundant memory cell array (30R), during a redundancy operation of said second normal memory cell array (20R).

7. A device according to any of the preceding claims, comprising a plurality of said first normal memory cell arrays (20L), each having an associated first redundant memory cell array (30L) and a first sense amplifier (40L); and a plurality of said second normal memory cell arrays (20R), each having an associated second redundant memory cell array (30R) and a second sense amplifier (40R).

**Patentansprüche**

1. Halbleiterspeichergerät, das eine Reihen-Redundanzschaltung aufweist und das umfaßt:

   eine erste normale Speicherzellenmatrix (20L), die eine zugeordnete erste Redundanz-Speicherzellenmatrix (30L) und einen ersten Leseverstärker (40L) aufweist; eine zweite normale Speicherzellenmatrix (20R), die an die erste normale Speicherzellenmatrix (20L) angrenzt und die eine zugeordnete zweite Redundanz-Speicherzellenmatrix (30R) und einen zweiten Leseverstärker (40R) aufweist;

wobei die ersten und zweiten Leseverstärker einen gemeinsam genutzten NMOS-Leseverstärker (41) zusammen mit ersten und zweiten PMOS-Leseverstärkern (40L1, 40R1) umfassen, wobei jeder von dem NMOS-Leseverstärker durch ein Isolationsgate (1,2; 3,4) getrennt ist, wobei die Isolationsgates durch besondere, separate Steuersignale (ØISOL, ØISOR) gesteuert werden;

eine erste Leseverstärker-Steuerungsschaltung (60L), die mit dem ersten Leseverstärker (40L) verbunden ist;

eine zweite Leseverstärker-Steuerungsschaltung (60R), die mit dem zweiten Leseverstärker (40R) verbunden ist;

ein erster Sicherungskasten (80L) zum Empfang einer Reihenadresse und eines Auswahlsignals der ersten normalen Speicherzellenmatrix (20L), wobei der erste Sicherungskasten (80L) sein Ausgangssignal mit den ersten und zweiten Leseverstärker-Steuerungsschaltungen (60L, 60R) gemeinsam verbunden hat; und

ein zweiter Sicherungskasten (80R) zum Erhalt einer Reihenadresse und eines Selektionssignals der zweiten normalen Speicherzellenmatrix (20R), wobei der zweite Sicherungskasten (80R) sein Ausgangssignal gemeinsam mit der ersten und zweiten Leseverstärker-Steuerungsschaltung (60L, 60R) verbunden hat;

wobei der erste Sicherungskasten (80L) betriebsfähig ist, um einen Redundanzvorgang der ersten normalen Speicherzellenmatrix (20L) zu programmieren, so daß die zweite Redundanz-Speicherzellenmatrix (30R) eine defekte Adresse der ersten normalen Speicherzellenmatrix (20L) repariert.

2. Halbleiterspeichergerät nach Anspruch 1, wobei im Gebrauch der gemeinsam genutzte NMOS-Leseverstärker schneller freigegeben wird als jeder der ersten und zweiten PMOS-Verstärker.

3. Gerät nach Anspruch 1 oder 2, wobei der Vorgang zur Reparatur der defekten Adresse ausgeführt wird, wenn die Anzahl der defekten Wortzeilen, die in der ersten normalen Speicherzellenmatrix (20L) hergestellt sind, größer ist als die Anzahl der in der ersten Redundanz-Speicherzellenmatrix (30L) verfügbaren redundanten Wortzeilen.

4. Halbleiterspeichergerät nach irgendeinem der vorangehenden Ansprüche, desweiteren umfassend:

einen ersten redundanten Wortzeilentreiber (70L) zur Freigabe der ersten redundanten Speicherzellenmatrix (30L); und

einen zweiten redundanten Wortzeilentreiber (70R) zur Freigabe der zweiten redundanten Speicherzellenmatrix (30R);

wobei der erste Sicherungskasten (80L) betriebsfähig ist, um die ersten und zweiten Leseverstärker-Steuerungsschaltungen (60L, 60R) während eines Redundanzvorgangs der ersten normalen Speicherzellenmatrix (20L) zu steuern.

5. Gerät nach Anspruch 4, wobei der Vorgang zur Steuerung der ersten und zweiten Leseverstärker-Steuerungsschaltungen (60L, 60R) ausgeführt wird, wenn die Anzahl der defekten Wortzeilen, die in der ersten normalen Speicherzellenmatrix (20L) hergestellt sind, größer ist als die Anzahl der in der ersten redundanten Speicherzellenmatrix (30L) verfügbaren redundanten Wortzeilen.

6. Gerät nach irgendeinem der vorangehenden Ansprüche, wobei der zweite Sicherungskasten (80R) betriebsfähig ist, um die ersten und zweiten Leseverstärker-Steuerungsschaltungen (60L, 60R) zu steuern, wenn die Anzahl der defekten Wortzeilen, die in der zweiten normalen Speicherzellenmatrix (20R) generiert werden, größer ist als die Anzahl der in der zweiten redundanten Speicherzellenmatrix (30R) verfügbaren redundanten Wortzeilen während eines Redundanzvorgangs der zweiten normalen Speicherzellenmatrix (20R).

7. Gerät nach irgendeinem der vorangehenden Ansprüche, umfassend eine Vielzahl der ersten normalen Speicherzellenmatrix (20L), wobei jede eine zugeordnete erste redundante Speicherzellenmatrix (30L) und einen ersten Leseverstärker (40L) aufweist; und eine Vielzahl der zweiten normalen Speicherzellenmatrix (20R), wobei jede eine zugeordnete zweite redundante Speicherzellenmatrix (30R) und einen zweiten Leseverstärker (40R) aufweist.

## Revendications

1. Dispositif de mémoire à semiconducteurs possédant un circuit à redondance de lignes, et comprenant:

un premier réseau normal de cellules de mémoire (20L) comportant un premier réseau associé redondant de celles de mémoire (30L) et un premier amplificateur de détection (40L);

un second réseau normal de cellules de mémoire (20R) adjacent audit premier réseau normal de cellules de mémoire (20L) et comportant un second réseau associé redondant de cellules de mémoire (30R) et un second amplificateur de détection (40R);

lesdits premier et second amplificateurs de détection comprenant un amplificateur de détection NMOS (41) utilisé en commun avec des premier et second amplificateurs de détection CMOS (40L1, 40R1), dont chacun est séparé de l'amplificateur de détection NMOS par une porte isolante (1, 2; 3, 4), les portes isolantes étant commandées par des signaux de commande séparés respectifs (ØISOL, ØISOR) ; un circuit (60L) de commande du premier amplificateur de détection connecté audit premier amplificateur de détection (40L); un circuit (60R) de commande du second amplificateur de détection connecté audit second amplificateur de détection (40R); une première boîte de fusibles (80L) servant à recevoir une adresse de ligne et un signal de sélection dudit premier réseau normal de cellules de mémoire (20L), le signal de sortie du premier boîtier de fusibles (80L) étant connecté en commun auxdits circuits (60L, 60R) de commande des premier et second amplificateurs de détection; et une seconde boîte de fusibles (80R) pour recevoir une adresse de ligne et un signal de sélection dudit second réseau normal de cellule de mémoire (20R), le signal de sortie de la seconde boîte de fusibles (80R) étant connecté en commun auxdits circuits (60L, 60R) des premier et second amplificateurs de détection; ladite première boîte de fusibles (80L) pouvant fonctionner de manière à programmer une opération de redondance dudit premier réseau normal de cellules de mémoire (20L) de sorte que ledit second réseau redondant de cellules de mémoire (30R) régénère une adresse défectueuse dudit premier réseau normal de cellule de mémoire (20L).

2. Dispositif de mémoire à semiconducteurs selon la revendication 1, dans lequel, en fonctionnement, l'amplificateur de détection NMOS utilisé en commun est activé plus rapidement que l'un ou l'autre des premier et second amplificateurs PMOS.

3. Dispositif selon la revendication 1 ou la revendication 2, dans lequel ladite opération de régénération de ladite adresse défectueuse est exécutée lorsque le nombre de lignes de mots défectueuses produites dans ledit premier réseau normal de cellules de mémoire (20L) est supérieur au nombre de lignes de mots redondantes disponibles dans ledit premier réseau redondant de cellules de mémoire (30L).

4. Dispositif de mémoire à semiconducteurs selon l'une quelconque des revendications précédentes, comprenant en outre:

un premier étage d'attaque redondant de lignes de mots (70L) pour valider ledit premier réseau redondant de cellules de mémoire (30L); et un second étage d'attaque redondant de lignes de mots (70R) pour valider ledit second réseau redondant de cellules de mémoire (30R); et ladite première boîte de fusibles (80L) pouvant fonctionner de manière à commander lesdits circuits (60L, 60R) de commande des premier et seconds amplificateurs de détection, pendant une opération de redondance dudit premier réseau normal de cellules de mémoire (20L).

5. Dispositif selon la revendication 4, dans lequel ladite opération de commande desdits circuits (60L, 60R) des premier et second amplificateurs de détection est exécutée lorsque le nombre de lignes de mots défectueuses produites dans ledit premier réseau normal de cellules de mémoire (20L) est supérieur au nombre de lignes de mots redondantes disponible dans ledit premier réseau redondant de cellules de mémoire (30L).

6. Dispositif selon l'une quelconque des revendications précédentes, dans lequel ladite seconde boîte de fusibles (80R) peut fonctionner de manière à commander lesdits circuits (60L, 60R) de commande des premier et second amplificateurs de détection, lorsque le nombre de lignes de mots défectueuses, produites dans ledit second réseau normal de cellules de mémoire (20R), est supérieur au nombre de lignes redondantes disponibles dans ledit second réseau redondant de cellules de mémoire (30R), pendant une opération de redondance dudit second réseau normal de cellule de mémoire (20R).

7. Dispositif selon l'une quelconque des revendications précédentes, comprenant une pluralité desdits premiers réseaux de cellules de mémoire (20L), dont chacun comporte un premier réseau associé redondant de cellules de mémoire (30L) et un premier amplificateur de détection (40L); et une pluralité desdits seconds réseaux normaux de cellules de mémoire (20R), dont chacun comporte un second réseau redondant associé de cellules de mémoire (30R) et un second amplificateur de détection (40R).

FIG. 1

*FIG. 2*

*FIG. 4*

FIG. 3

EP 0 579 366 B1

FIG. 5A

FIG. 5B

FIG. 6A

FIG. 6B

FIG. 6C

*FIG. 7A*

*FIG. 7B*

*FIG. 8A*

*FIG. 8B*

EP 0 579 366 B1